# EUROPEAN PATENT SPECIFICATION

(11) **EP 3 745 216 B1**
(45) Date of publication and mention of the grant of the patent: **15.09.2021**
(21) Application number: 19177213.6
(22) Date of filing: 29.05.2019
(51) Int. Cl.: G04F 5/14, G01R 33/383, G01V 3/32, G01R 33/44

(54) **NMR ATOMIC CLOCK**
NMR-ATOMUHR
HORLOGE ATOMIQUE À RMN

(43) Date of publication of application: 02.12.2020
(73) Proprietor: Airbus Defence and Space GmbH, 82024 Taufkirchen (DE)
(72) Inventor: BARTUSCH, Tobias, 82024 Taufkirchen (DE)
(74) Representative: Frenkel, Matthias Alexander

(56) References cited:
- EP-A1- 3 112 853
- US-B1- 8 816 784
- US-B2- 7 173 421

## Description

Examples relate to concepts for providing a reference frequency and applications thereof, for example an NMR based atomic clock, and in particular to a physics package for an Oscillator and an Oscillator having the same.

Atomic clocks are used for frequency references which are necessary to be ultrastable. They are used e.g. in the Galileo (navigation) System or in cellular stations or in radio astronomy applications. Rubidium Atomic Frequency Source, RAFS, is a known clock type. The RAFS has some disadvantages: High inner temperatures are necessary, very critical physical process, complex technology, intense in adjustment, shipping and assembly is complex because of the content of metallic Rubidium which must be precisely filled in two different glass containers in a complex handling. The technology is very sensitive against magnetic influences and has also micro vibration sensitive behaving. The Rubidium moves into the glass walls of the containers because of the necessary high temperatures and forces aging over life time.

Frequency references may have to be optimized with respect to at least one of the above-mentioned disadvantages.

US 7173421 B2 discloses a Nuclear Magnetic Resonance (NMR) (Nuclear Spin Resonance (NSR)) atomic clock. Two permanent magnets are used for creating a (relatively weak) DC magnetic field. Two electromagnetic coils (230 in Figure 6) are used as antennae for applying/sending a weak RF signal (for spin flipping) on the one hand and for outputting/receiving a clock signal on the other.

There may be a demand to provide concepts for an improved frequency reference in consideration of at least one of the above-mentioned disadvantages.

Such a demand may be satisfied by the subject-matter of the claims.

According to a first aspect, a Physics Package for an Oscillator according to claim 1 is provided.

The first and second permanent magnets may be arranged in a distance such that a predetermined magnitude of the static magnetic field is constructed inside the space. The predetermined magnitude corresponds to a nuclear magnetic resonance condition for continuous wave operation.

The space may be a cuboid, for example a cube. The space may have a cubic form. The space may also be cubic. The space may be a cylinder.

Each of the first and second permanent magnet, and the first and second RF coils are arranged such that each of them forms part of different sides of the cuboid. The first and second permanent magnets may be arranged at respective top and bottom sides of the cylinder. The first and second RF coils may be arranged on a lateral surface of the cylinder. The first and second RF coils may be displaced in circumferential direction around the cylinder by an angle of 90°.

The first and second permanent magnets may be arranged at opposite sides of the cuboid. The first and second permanent magnets may be arranged at opposite sides of the cylinder.

The first and second RF coils may be arranged at neighboring sides of the cuboid. The first and second RF coils may be arranged at the lateral surface of the cylinder. The first and second RF coils may be displaced in circumferential direction of the cylinder by an angle of 90°.

The first and second RF coils may each form a plane corresponding to respective sides of the cuboid.

The cuboid may be constructed by the first and second permanent magnets together with the first and second RF coils. The cylinder may be constructed by the first and second permanent magnets together with the first and second RF coils.

For example, the first and second RF coils are not at opposite sides of the space. Further, for example the first and second RF coils are not at same sides as the first and second permanent magnets. The first and second RF coils may be arranged (in a 90 degree angle around the space) between the first and second permanent magnets.

Respective normal vectors associated with the first and second RF coils may be perpendicular to each other.

Respective normal vectors of the first and second RF coils may construct a plane which is perpendicular to a preferred direction of the static magnetic field.

The Physics Package may further comprise a DC coil for providing another static magnetic field. The DC coil may be arranged circumferentially around the cylinder or cuboid. The DC coil may be adapted to adjust (a strength of) the magnetic field generated by the first and second permanent magnets.

The DC coil may be adapted to generate the other static magnetic field in a direction parallel to a direction of the static magnetic field generated by the first and second permanent magnetic fields.

The direction of the other static magnetic field may preferably be in a direction perpendicular to a normal vector of the second RF coil.

The Physics Package may further comprise an iron cask. The iron cask may be arranged and adapted to surround the space such that contrary poles of the first and second permanent magnets are connected with each other.

The iron cask may be adapted and arranged to encircle the space.

The iron cask may surround the first and second permanent magnets, the first and second RF coils and the NMR sample (as well as the DC coil).

According to a second aspect, an oscillator for providing an output frequency is provided. The oscillator comprises the Physics Package according to the first aspect.

The NMR based clock as described with respect to the oscillator including the Physics Package may be less sensitive against external influences because it involves a different physical process. It may avoid high temperatures, frequencies above few hundred MHz, and may contain only non-dangerous reference materials (for example H2O, Y2O3 or similar materials). The aging of the reference may be suppressed and the handling of the lower frequencies may be much easier. For example the reference frequency may be in a range from 35 to 150 MHz, in particular 38 to 45 MHz. The main setup of the oscillator circuit (herein described as oscillator) may be mostly comparable to a continuous wave NMR (no longer used for medical applications) and can roughly be described as a mixture between NMR and a YIG (Yttrium Iron Garnet) oscillator.

One of the aspects herein may be to replace the RAFS for in orbit applications with augmented lifetime and reduced aging - especially because of the absence of a plasma lamp, lower frequencies and non-hazardous materials. Because of the simplification of handling processes, the costs can be significantly reduced and the failure rate can improve (less complex technology at lower temperature which can fail). An advantage may be that the frequency can be easily set by a digital control word.

It is clear to a person skilled in the art that the statements set forth herein under use of hardware circuits; software means or a combination thereof may be implemented. The software means can be related to programmed microprocessors or a general computer, an ASIC (Application Specific Integrated Circuit) and/or DSPs (Digital Signal Processors). For example, the oscillator may be implemented partially as a computer, a logical circuit, an FPGA (Field Programmable Gate Array), a processor (for example, a microprocessor, microcontroller (µC) or an array processor)/a core/a CPU (Central Processing Unit), an FPU (Floating Point Unit), NPU (Numeric Processing Unit), an ALU (Arithmetic Logical Unit), a Coprocessor (further microprocessor for supporting a main processor (CPU)), a GPGPU (General Purpose Computation on Graphics Processing Unit), a multi-core processor (for parallel computing, such as simultaneously performing arithmetic operations on multiple main processor(s) and/or graphical processor(s)) or a DSP. It is further clear to the person skilled in the art that even if the herein-described details will be described in terms of a method, these details may also be implemented or realized in a suitable device, a computer processor or a memory connected to a processor, wherein the memory can be provided with one or more programs that perform the method, when executed by the processor. For that, methods like swapping and paging can be deployed.

Even if some of the aspects described above have been described in reference to the physics package, these aspects may also apply to the oscillator. Likewise, the aspects described above in relation to the oscillator may be applicable in a corresponding manner to the physics package.

It is to be understood that terms such as e.g. "comprising" "including" or "having" etc. mean the presence of the described features, numbers, operations, acts, components, parts, or combinations thereof, and do not exclude the presence or possible addition of one or more further features, numbers, operations, acts, components, parts or their combinations.

Although terms like "first" or "second" etc. may be used to describe different components or features, these components or features are not to be limited to these terms. With the above terms, only one component is to be distinguished from the other. For example, a first component may be referred to as a second component without departing from the scope of the present disclosure; and a second component may also be referred to as a first component. The term "and/or" includes both combinations of the plurality of related features, as well as any feature of that plurality of the described plurality of features.

In the present case, if a component is "connected to", "in communication with" or "accesses" another component, this may mean that it is directly connected to or directly accesses the other component; however, it should be noted that another component may be therebetween. If, on the other hand, a component is "directly connected" to another component or "directly accesses" the other component, it is to be understood that no further components are present therebetween.

In the following, the preferred embodiments of the present disclosure will be described with reference to the accompanying drawings; the same or similar components are always provided with the same or similar reference symbols. In the description of the present disclosure, detailed explanations of known connected functions or constructions are omitted, insofar as they are unnecessarily distracting from the present disclosure. The accompanying drawings are illustrative of the present disclosure and are not to be construed as a limitation.

Other objects, features, advantages and applications will become apparent from the following description of non-limiting embodiments regarding the accompanying drawings. In the drawings, all described and/or illustrated features, alone or in any combination form the subject matter disclosed therein, irrespective of their grouping in the claims or their relations/references. The dimensions and proportions of components or parts shown in the figures are not necessarily to scale; these dimensions and proportions may differ from illustrations in the figures and implemented embodiments.
- Figure 1: schematically illustrates a physics package for an oscillator from a first perspective;
- Figure 2: schematically illustrates a physics package for an oscillator from a second perspective;
- Figure 3: schematically illustrates an oscillator circuit for providing an output frequency and respective building blocks, as well as physics loop and phase locked loop;
- Figure 4: schematically illustrates an oscillator circuit for providing an output frequency and respective building blocks, as well as Analog and FPGA implementation details; and
- Figure 5: schematically illustrates an oscillator circuit for providing an output frequency and respective building blocks, as well as thermal sensitive circuits.

The physics package and the oscillator will now be described with respect to the embodiments.

In the following, without being restricted thereto, specific details are set forth to provide a thorough understanding of the present disclosure. However, it is clear to the skilled person that the present disclosure may be used in other embodiments, which may differ from the details set out below.

It will be understood that when an element is referred to as being "connected" or "coupled" to another element, the elements may be directly connected or coupled or via one or more intervening elements. If two elements A and B are combined using an "or", this is to be understood to disclose all possible combinations, i.e. only A, only B as well as A and B. An alternative wording for the same combinations is "at least one of A and B". The same applies for combinations of more than 2 elements.

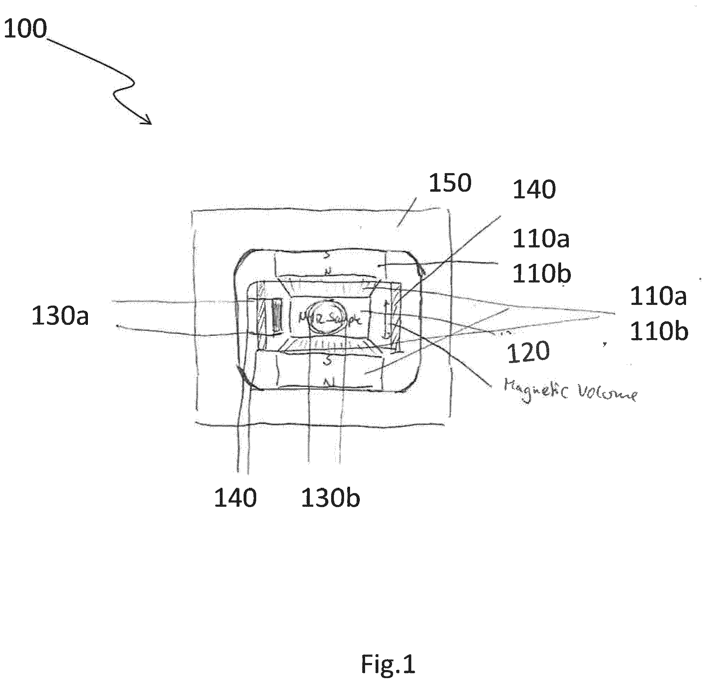

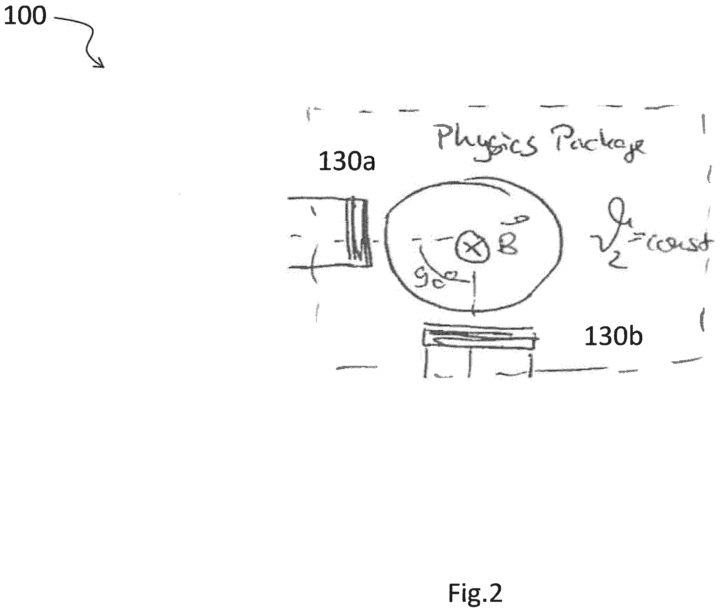

Figure 1 schematically illustrates a physics package (100) for an oscillator (200) from a first perspective. Figure 2 schematically illustrates a physics package (100) for an oscillator (200) from a second perspective. The Physics Package (100) is provided for an Oscillator (200). The Physics Package (100) comprises first and second permanent magnets (110a, 110b). The first and second permanent magnets (110a, 110b) are arranged to form a space between each other. The first and second permanent magnets (110a, 110b) are adapted to generate a static magnetic field inside the space. The first and second permanent magnets (110a, 110b) may be adapted to equalize the static magnetic field strength. The magnetic field has a direction from the first permanent magnet (110a) to the second permanent magnet (110b). The Physics Package (100) further comprises a Nuclear Magnetic Resonance, NMR, sample (120). The NMR sample is arranged inside the space. The Physics Package (100) further comprises first and second radio frequency, RF, coils (130a, 130b). The first and second RF coils (130a, 130b) are arranged at different sides of the space in an angle of 90° to each other. The first RF coil (130a) is adapted to introduce an RF pulse into the space. This results in a precession of atomic cores of the NMR sample (120). The second RF coil (130b) is adapted to measure the precession of the atomic cores of the NRM sample (120).

The first and second permanent magnets (110a, 110b) may be arranged in a distance such that a predetermined magnitude of the static magnetic field is constructed inside the space. The predetermined magnitude corresponds to a nuclear magnetic resonance condition for continuous wave operation.

The space may be a cuboid, for example a cube. The space may have a cubic form. The space may also be cubic. The space may also be a cylinder.

Each of the first and second permanent magnet (110a, 110b), and the first and second RF coils (130a, 130b) are arranged such that each of them forms part of different sides of the cuboid. The first and second permanent magnets (110a, 110b) may be arranged at respective top and bottom sides of the cylinder. The first and second RF coils (130a, 130b) may be arranged on a lateral surface of the cylinder. The first and second RF coils (130a, 130b) may be displaced in circumferential direction around the cylinder by an angle of 90°.

The first and second permanent magnets (110a, 110b) may be arranged at opposite sides of the cuboid. The first and second permanent magnets (110a, 110b) may be arranged at opposite sides of the cylinder.

The first and second RF coils (130a, 130b) may be arranged at neighboring sides of the cuboid. The first and second RF coils (130a, 130b) may be arranged at the lateral surface of the cylinder. The first and second RF coils (130a, 130b) may be displaced in circumferential direction of the cylinder by an angle of 90°.

The first and second RF coils (130a, 130b) may each form a plane corresponding to respective sides of the cuboid.

The cuboid may be constructed by the first and second permanent magnets (110a, 110b) together with the first and second RF coils (130a, 130b). The cylinder may be constructed by the first and second permanent magnets (110a, 110b) together with the first and second RF coils (130a, 130b).

For example, the first and second RF coils (130a, 130b) are not at opposite sides of the space. Further, for example the first and second RF coils (130a, 130b) are not at same sides as the first and second permanent magnets (110a, 110b). The first and second RF coils (130a, 130b) may be arranged (in a 90 degree angle around the space) between the first and second permanent magnets (110a, 110b).

Respective normal vectors associated with the first and second RF coils (130a, 130b) may be perpendicular to each other.

Respective normal vectors of the first and second RF coils (130a, 130b) may construct a plane which is perpendicular to a preferred direction of the static magnetic field.

The Physics Package (100) may further comprise a DC coil (140) for providing another static magnetic field. The DC coil (140) may be arranged around an axis of the static magnetic field. The DC coil (140) may be arranged circumferentially around the cylinder or cuboid. The DC coil may be adapted to adjust (a strength of) the magnetic field generated by the first and second permanent magnets (110a, 110b).

The DC coil (140) may be adapted to generate the other static magnetic field in a direction parallel to a direction of the static magnetic field generated by the first and second permanent magnetic fields (110a, 110b).

The direction of the other static magnetic field may preferably be in a direction perpendicular to a normal vector of the second RF coil (130b).

The DC coil (140) may surround the first and second RF coils (130a, 130b). The DC coil (140) may be arranged rotationally symmetrical.

The Physics Package (100) may further comprise an iron cask (150). The iron cask (150) may be arranged and adapted to surround the space such that contrary poles of the first and second permanent magnets (110a, 110b) are connected with each other.

The iron cask (150) may be adapted and arranged to encircle the space.

The iron cask (150) may surround the first and second permanent magnets, the first and second RF coils and the NMR sample (as well as the DC coil).

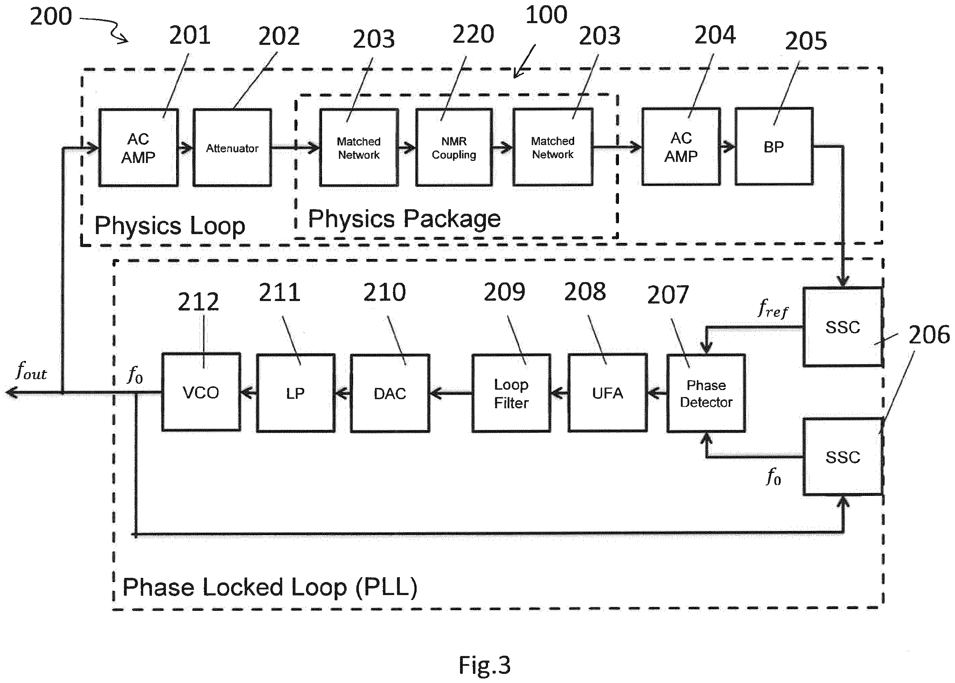

More details and aspects are mentioned in connection with the embodiments described above or below. The embodiment shown in Fig. 1 -2 may comprise one or more optional additional features corresponding to one or more aspects mentioned in connection with the proposed concept or one or more embodiments described above or below (e.g. Fig. 3 - 5).

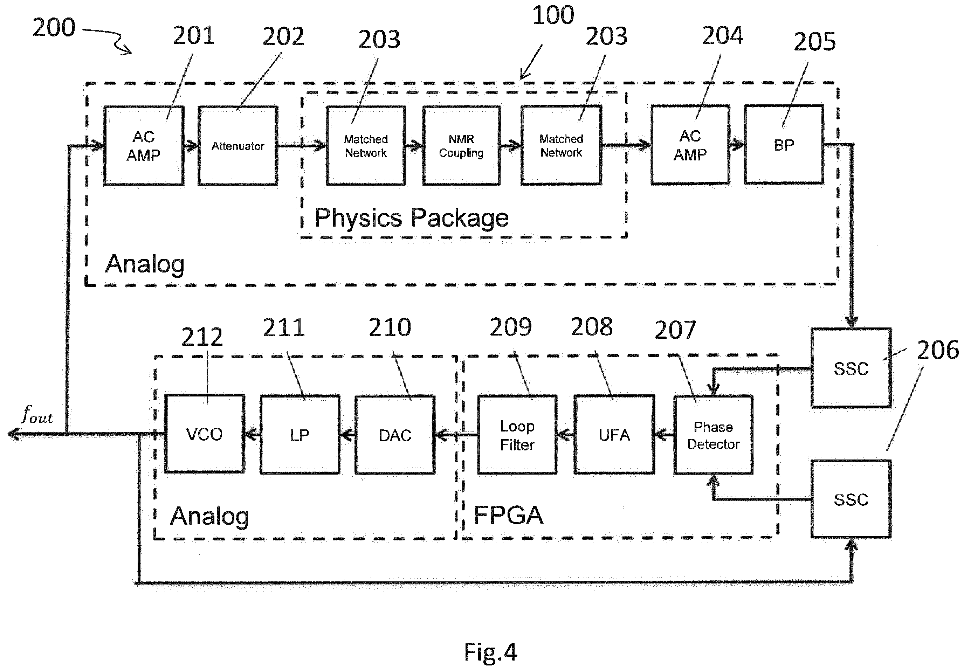

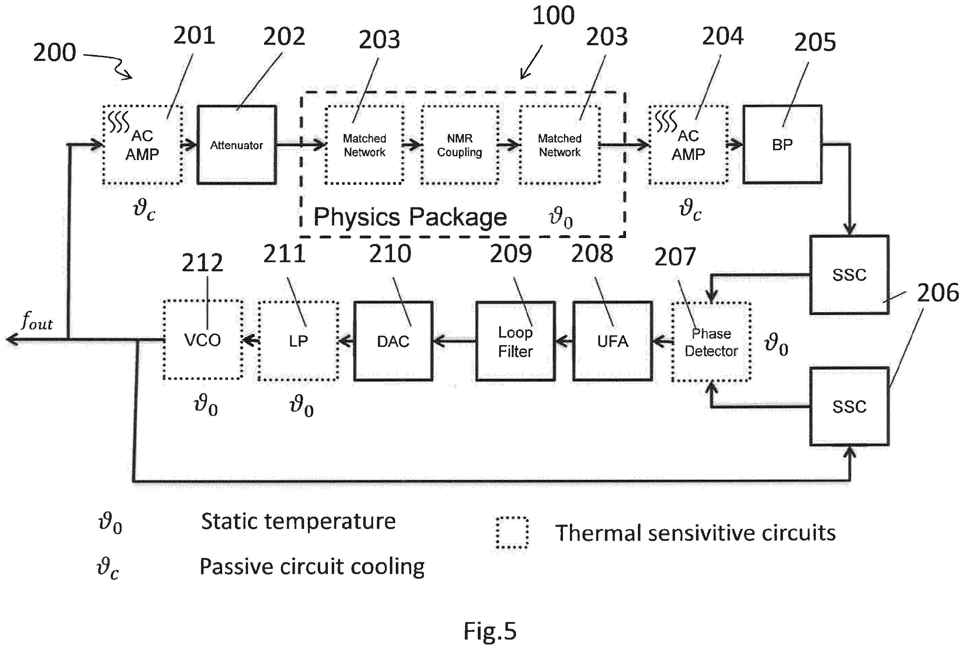

Figure 3 schematically illustrates an oscillator circuit (200) for providing an output frequency and respective building blocks, as well as physics loop and phase locked loop. Furthermore, figure 4 schematically illustrates an oscillator circuit (200) for providing an output frequency and respective building blocks, as well as Analog and FPGA implementation details. In addition, figure 5 schematically illustrates an oscillator circuit (200) for providing an output frequency and respective building blocks, as well as thermal sensitive circuits. The oscillator (200) provides an output frequency. The oscillator (200) comprises the Physics Package (100) according to the first aspect.

The oscillator circuit (200) in Fig. 3 - 5 comprises exemplary an Input Amplifier (201). The Input Amplifier (201) decouples the NMR input from output signal of the phased locked loop, PLL. The Input Amplifier (201) can improve an SNR (due to a High Gain). Further, the Input Amplifier (201) makes sure that input signal strength stays constant. However, high Power Amplifier is susceptible for heating up. The important parameters of the Input Amplifier (201) are: High Gain, Low Phase Noise and/or Linearity.

The oscillator circuit (200) in Fig. 3 - 5 further comprises exemplary an Attenuator (202). The Attenuator (202) is connected to the Input Amplifier (201). The Attenuator (202) damps the input signal, especially reflected signals. Since the matched network (203) is not ideal, this may be important for protecting the high power amplifier 201 from unwanted reflected signals. In simulation, this can be considered as a PD-Unit. Important parameter of the Attenuator (202) is the damping factor.

The oscillator circuit (200) in Fig. 3 - 5 further comprises exemplary a Matched Network (203) which is connected downstream to the attenuator (202). The Matched Network (203) impedance matches from PLL to NMR Coupling (220). The Matched Network (203) minimizes reflections and maximizes throughput. The Matched Network (203) can also be considered as PD-Unit in simulation. Important parameters of the Matched Network (203) are Input Impedance and Output Impedance.

The oscillator circuit (200) in Fig. 3 - 5 further comprises exemplary an NMR Coupling (220) connected downstream to the Matched Network (203). The NMR Coupling could be referred to as the Physics Package (100) or part of the Physics Package (100) as described with respect to Fig. 1 - 2. The NMR Coupling (220) may be the core of the oscillator circuit (200). The NMR Coupling (220) provides the reference frequency. In particular as described similarly with respect to Fig. 1 - 2, the NMR coupling (220) has a magnet, 2 RF coils and a reference substance. The NMR Coupling (220) uses Nuclear Magnetic Resonance. However, the NMR Coupling (220) is Temperature critical and may need to keep a constant temperature. Isolation and EM-Shielding may be provided, for example in form of the iron cask or different measures. The NMR Coupling (220) can be modeled as an RF channel. The output signal of the NMR Coupling (220) may be very weak and noisy.

The oscillator circuit (200) in Fig. 3 - 5 further comprises exemplary an Output Amplifier (204) connected downstream to the NMR Coupling (220). The Output Amplifier (204) decouples the NMR output from the PLL. The Output Amplifier (204) may be a Low Phase Noise Amplifier. Further, the Output Amplifier (204) makes sure that the output signal strength stays constant. Moreover, the Output Amplifier (204) improves the SNR for the downstream connected Bandpass Filter (205). Important Parameters of the Output Amplifier (204) are Low Phase Noise and Linearity.

The oscillator circuit (200) in Fig. 3 - 5 further comprises exemplary a Bandpass Filter (205) connected downstream to the Output Amplifier (204). The Bandpass Filter (205) filters relevant reference frequencies from noise and harmonics. Further, the Bandpass Filter (205) produces a low bandwidth signal and prepares the signal for the downstream connected SSC. Important Parameters of the Bandpass Filter (205) are Low Phase Noise and High Q Factor.

The oscillator circuit (200) in Fig. 3 - 5 further comprises exemplary a Sinus Square Converter (206) connected downstream to the Bandpass Filter (205). The Sinus Square Converter (206) prepares the signal for sampling. Important Parameters of the Sinus Square Converter (206) is Low Phase Noise.

The oscillator circuit (200) in Fig. 3 - 5 further comprises exemplary a Phase Detector (207) connected downstream to the Sinus Square Converter (206). The Phase Detector (207) detects a difference in phase between the reference signal and the output signal. The phase difference correlates with a frequency difference which should be zero. Important Parameters of the Phase Detector (207) are Linearity, Low phase noise, No dead band and Pull-In Range. The Design may be in the form of a PFD, XOR, JK-FF and/or Differential PFD.

The oscillator circuit (200) in Fig. 3 - 5 further comprises exemplary an Unambiguous Frequency Aid (208) connected downstream to the Phase Detector (207). The Unambiguous Frequency Aid (208) connected improves Pull-In range. The Unambiguous Frequency Aid (208) connected may be implemented in FPGA. Further, the Unambiguous Frequency Aid (208) connected improves system stability against cycle slips and improves SNR.

The oscillator circuit (200) in Fig. 3 - 5 further comprises exemplary a Loop Filter (209) connected downstream to the Unambiguous Frequency Aid (208). The Loop Filter (209) may be a digital implementation in FPGA. The Loop Filter (209) may be the core of the PLL and makes sure the terminal value of the phase difference is zero. The order of the Loop Filter (209) may be at least of order 1, e.g. 1 ideal integrator to achieve a terminal phase error of 0. A higher order filter may reduce stability but can improve the overall system (oscillator) performance. Digital implementation of the Loop Filter (209) may provide room for optimization.

The oscillator circuit (200) in Fig. 3 - 5 further comprises exemplary a Digital-to-Analog Converter (210) connected downstream to the Loop Filter (209). The Digital-to-Analog Converter (210) converts the digital signal into an analog signal for the Voltage Controlled Oscillator (212). The Voltage Controlled Oscillator (212) may have a high resolution.

The oscillator circuit (200) in Fig. 3 - 5 further comprises exemplary a Lowpass Filter (211) connected downstream to the Digital Analog Converter (210). The Lowpass Filter (211) converts the signal from the Digital Analog Converter (210) into a smooth DC voltage. The Digital Analog Converter (210) filters out any unwanted frequencies for the oscillator control signal. The critical Part is that any unsuppressed frequencies may be modulated onto the output signal as phase noise. The Digital Analog Converter (210) may act as ideal integrator.

The oscillator circuit (200) in Fig. 3 - 5 further comprises exemplary a Voltage Controlled Oscillator (212) connected downstream to the Lowpass Filter (211). The Voltage Controlled Oscillator (212) produces the output frequency from the control voltage as supplied by the Lowpass Filter (211). Any phase noise created here may be transmitted into the output signal. The Voltage Controlled Oscillator (212) may be temperature controlled, and all outputs may be decoupled (no load). The Voltage Controlled Oscillator (212) may act as ideal integrator. Important Parameters may be Low Phase Noise, Stability and Linearity. The Voltage Controlled Oscillator (212) may be mainly responsible for the short term performance of the clock (~10s). For example, Voltage controlled Temperature compensated Temperature controlled Quartz Oscillator, VCTCTCXO, may be used.

More details and aspects are mentioned in connection with the embodiments described above or below. The embodiment shown in Fig. 3 - 5 may comprise one or more optional additional features corresponding to one or more aspects mentioned in connection with the proposed concept or one or more embodiments described above (e.g. Fig. 1 - 2) or below.

One or more aspects may be based on the coupling between two 90 degree angled coils when the Nuclear magnetic resonance condition is fulfilled (continuous wave - CW-Operation). This may depend on the magnetic field which is provided by permanent magnet(s) (normal NMR resonance equation). The resonance may be tracked by a FLL (Frequency Locked Loop). The tracking frequency which is a directly depending on the NMR resonance (which is planned to be set on ~90..100MHz) may also be the entry frequency of a DDS (Direct Digital Sinewave synthesizer).The fine tuning can be accomplished by adjusting the magnetic field with a DC coil in the physics package. This coil can also be used for temperature effect compensation or aging effects. Additionally the temperature of all components may be (at a lower temperature than usual) stabilized in order to decouple the mechanic properties of the Physics Package from the temperature variations. The VCO may need to be a very stable version (TCXO - Temperature compensated Quartz Oscillator) to ensure the proper operation of the setup.

For example, Nuclear Magnetic Resonance uses the fact that some atomic cores start to oscillate just like electrons in ferri- and ferromagnetic materials. Although the basic mechanism is the same, a precession, the physical nature of this phenomenon is different. When a static magnetic field is applied to an element with an intrinsic nuclear spin the cores align appropriately. By introducing an RF pulse, the atomic cores may begin to precess. This movement can be measured by a different RF coil. Due to the nature of this effect, the signal may be rather weak (low SNR) and may need a lot of filtering and amplifying. Such a low bandwidth spectrum may be ideal as a frequency reference.

There are 4 different types of magnetism, namely diamagnetism, paramagnetism, ferri-/antiferrimagnetism and ferromagnetism. While every element is diamagnetic, only a few, like YIG, are intrinsically magnetic. Those elements exhibit a strong order due to the magnetic dipole moment associated with the electron spin. When an external magnetic field is applied, electrons align with this field. Depending on the material used, this effect can be rather strong.

On the other hand there are mostly non-magnetic materials like H² or C. They are not as strongly affected by an external magnetic field, because their electron configuration is different. In essence, this means only mostly static effects like induced changes in orbits of electrons contribute to a magnetic order. As a result diamagnetism is only observable in substances which do not exhibit a stronger form of magnetism. Thus, the NMR sample described in one or more aspects above may be diamagnetic.

Similar to the electrons, the core also holds a certain nuclear spin. Depending on the count of protons and neutrons, atomic cores react to an external magnetic field, just like electrons in diamagnetic substances do. This effect is much weaker and only visible at a certain resonance frequency. This spike can be measured and can be used in a Nuclear Magnetic Resonance Loop.

In contrast to a YIG Oscillator, the NMR based oscillator (atomic clock) does not use ferrimagentic nature of its carrier material. YIG's resonance is an effect caused by precession of electrons, wherein NMR's resonance is based on precision of atomic cores. Thus, an NMR loop may use the nuclear spin of certain atomic cores which is only observable in otherwise mostly non-magnetic (e.g. diamagnetic) substances. Both (YIG and NMR) make use of a precession movement inside an atom, but on different levels. The Nuclear Magnetic Resonance is a much weaker effect and thus a lot of signal processing may be needed.

When observing NMR, the magnetic effects of the electrons may be considered noise and are generally unwanted.

## Claims

1. A Physics Package (100) for an Oscillator (200), comprising:
first and second permanent magnets (110a, 110b) arranged to form a space between each other and adapted to generate a static magnetic field inside the space in a direction from the first permanent magnet (110a) to the second permanent magnet (110b);
a Nuclear Magnetic Resonance, NMR, sample (120) arranged inside the space; first and second radio frequency, RF, coils (130a, 130b), wherein the first RF coil (130a) is adapted to introduce an RF pulse into the space resulting in a precession of atomic cores of the NMR sample (120), and wherein the second RF coil (130b) is adapted to measure the precession of the atomic cores of the NRM sample (120), **characterised in that** the first and second radio frequency, RF, coils (130a, 130b) are arranged at different sides of the space in an angle of 90° to each other.

2. The Physics Package (100) according to claim 1, wherein the first and second permanent magnets (110a, 110b) are arranged in a distance such that a predetermined magnitude of the static magnetic field is constructed inside the space, wherein the predetermined magnitude corresponds to a nuclear magnetic resonance condition for continuous wave operation.

3. The Physics Package (100) according to claim 1 or 2, wherein the space is a cylinder or cuboid, for example a cube.

4. The Physics Package (100) according to claim 3, wherein each of the first and second permanent magnet (110a, 110b), and the first and second RF coils (130a, 130b) are arranged such that each of them forms part of different sides of the cuboid; or
wherein the first and second permanent magnets (110a, 110b) are arranged at respective top and bottom sides of the cylinder, and wherein the first and second RF coils (130a, 130b) are arranged on a lateral surface of the cylinder, wherein the first and second RF coils (130a, 130b) are displaced in circumferential direction by an angle of 90°.

5. The Physics Package (100) according to claim 3 or 4, wherein the first and second permanent magnets (110a, 110b) are arranged at opposite sides of the cylinder or cuboid.

6. The Physics Package (100) according to any one of claims 3 to 5, wherein the first and second RF coils (130a, 130b) are arranged at neighboring sides of the cuboid or at the lateral surface of the cylinder displaced in circumferential direction of the cylinder by an angle of 90°.

7. The Physics Package (100) according to any one of claims 3 to 6, wherein the cylinder or cuboid is constructed by the first and second permanent magnets (110a, 110b) together with the first and second RF coils (130a, 130b).

8. The Physics Package (100) according to any one of the foregoing claims, wherein respective normal vectors associated with the first and second RF coils (130a, 130b) are perpendicular to each other.

9. The Physics Package (100) according to claim 8, wherein the respective normal vectors of the first and second RF coils (130a, 130b) construct a plane which is perpendicular to a preferred direction of the static magnetic field.

10. The Physics Package (100) according to any one of the foregoing claims, further comprising a DC coil (140) for providing another static magnetic field, wherein the DC coil (140) is arranged circumferentially around the cylinder or the cuboid, and wherein the DC coil (140) is adapted to adjust the magnetic field generated by the first and second permanent magnets (110a, 110b).

11. The Physics Package (100) according to claim 10, wherein the DC coil (140) is adapted to generate the other static magnetic field in a direction parallel to a direction of the static magnetic field generated by the first and second permanent magnetic fields (110a, 110b).

12. The Physics Package (100) according to claim 11, wherein the direction of the other static magnetic field is preferably in a direction perpendicular to a normal vector of the second RF coil (130b).

13. The Physics Package (100) according to any one of the foregoing claims, further comprising an iron cask (150) arranged and adapted to surround the space such that contrary poles of the first and second permanent magnets (110a, 110b) are connected with each other.

14. An oscillator (200) for providing an output frequency, wherein the oscillator (200) comprises the Physics Package (100) according to any one of the foregoing claims.

## Patentansprüche

1. Ein Physikpaket (100) für einen Oszillator (200), umfassend:
einen ersten und einen zweiten Permanentmagneten (110a, 110b), die angeordnet sind, einen Raum zwischen sich zu bilden, und die so angepasst sind, ein statisches Magnetfeld innerhalb des Raums in einer Richtung von dem ersten Permanentmagneten (110a) zu dem zweiten Permanentmagneten (110b) zu erzeugen;
eine Kernspinresonanz, NMR, -Probe (120), die in dem Raum angeordnet ist;
eine erste und eine zweite Hochfrequenz, HF, -Spule (130a, 130b), wobei die erste RF-Spule (130a) ausgebildet ist, einen Hochfrequenzimpuls in den Raum einzuführen, der zu einer Präzession von Atomkernen der NMR-Probe (120) führt, und wobei die zweite HF-Spule (130b) ausgebildet ist, die Präzession der Atomkerne der NMR-Probe (120) zu messen, **dadurch gekennzeichnet, dass** die erste und die zweite HF-Spule (130a, 130b) an verschiedenen Seiten des Raums in einem Winkel von 90° zueinander angeordnet sind.

2. Physikpaket (100) nach Anspruch 1, wobei der erste und der zweite Permanentmagnet (110a, 110b) in einem solchen Abstand angeordnet sind, dass eine vorbestimmte Größe des statischen Magnetfeldes innerhalb des Raumes aufgebaut wird, wobei die vorbestimmte Größe einer kernmagnetischen Resonanzbedingung für den Dauerstrichbetrieb entspricht.

3. Physikpaket (100) nach Anspruch 1 oder 2, wobei der Raum ein Zylinder oder Quader ist, beispielsweise ein Würfel.

4. Physikpaket (100) nach Anspruch 3, wobei jeder des ersten und des zweiten Permanentmagnets (110a, 110b) sowie der ersten und der zweiten HF-Spule (130a, 130b) jeweils so angeordnet sind, dass jeder von ihnen einen Teil verschiedener Seiten des Quaders bilden; oder
wobei der erste und der zweite Permanentmagnet (110a, 110b) an der jeweiligen Ober- und Unterseite des Zylinders angeordnet sind, und wobei die erste und die zweite HF-Spule (130a, 130b) an einer Seitenfläche des Zylinders angeordnet sind, wobei die erste und die zweite RF-Spule (130a, 130b) in Umfangsrichtung um einen Winkel von 90° versetzt sind.

5. Physikpaket (100) nach Anspruch 3 oder 4, wobei der erste und zweite Permanentmagnet (110a, 110b) an gegenüberliegenden Seiten des Zylinders oder Quaders angeordnet sind.

6. Physikpaket (100) nach einem der Ansprüche 3 bis 5, wobei die erste und die zweite HF-Spule (130a, 130b) an benachbarten Seiten des Quaders oder an der in Umfangsrichtung des Zylinders um einen Winkel von 90° versetzten Seitenfläche des Zylinders angeordnet sind.

7. Physikpaket (100) nach einem der Ansprüche 3 bis 6, wobei der Zylinder oder Quader durch den ersten und zweiten Permanentmagneten (110a, 110b) zusammen mit der ersten und zweiten HF-Spule (130a, 130b) gebildet wird.

8. Physikpaket (100) nach einem der vorhergehenden Ansprüche, wobei die jeweiligen Normalenvektoren, die der ersten und zweiten HF-Spule (130a, 130b) zugeordnet sind, senkrecht zueinander stehen.

9. Physikpaket (100) nach Anspruch 8, wobei die jeweiligen Normalenvektoren der ersten und zweiten HF-Spule (130a, 130b) eine Ebene bilden, die senkrecht zu einer bevorzugten Richtung des statischen Magnetfelds steht.

10. Physikpaket (100) nach einem der vorhergehenden Ansprüche, ferner umfassend eine Gleichstromspule (140) zum Bereitstellen eines weiteren statischen Magnetfeldes, wobei die Gleichstromspule (140) in Umfangsrichtung um den Zylinder oder den Quader herum angeordnet ist, und wobei die Gleichstromspule (140) ausgebildet ist, das von dem ersten und zweiten Permanentmagneten (110a, 110b) erzeugte Magnetfeld einzustellen.

11. Physikpaket (100) nach Anspruch 10, wobei die Gleichstromspule (140) ausgebildet ist, das andere statische Magnetfeld in einer Richtung parallel zu einer Richtung des statischen Magnetfeldes zu erzeugen, das durch das erste und zweite Permanentmagnetfeld (110a, 110b) erzeugt wird.

12. Physikpaket (100) nach Anspruch 11, wobei die Richtung des anderen statischen Magnetfeldes vorzugsweise in einer Richtung senkrecht zu einem Normalenvektor der zweiten HF-Spule (130b) liegt.

13. Physikpaket (100) nach einem der vorangehenden Ansprüche, ferner umfassend einen Eisenkasten (150), der angeordnet und angepasst ist, den Raum so zu umgeben, dass gegensätzliche Pole des ersten und zweiten Permanentmagneten (110a, 110b) miteinander verbunden sind.

14. Oszillator (200) zum Bereitstellen einer Ausgangsfrequenz, wobei der Oszillator (200) das Physikpaket (100) nach einem der vorangehenden Ansprüche umfasst.

## Revendications

1. Boîtier physique (100) pour un oscillateur (200), comprenant :
un premier et un second aimant permanent (110a, 110b) disposés de manière à former un espace entre eux et conçus pour générer un champ magnétique statique à l'intérieur de l'espace dans une direction à partir du premier aimant permanent (110a) vers le second aimant permanent (110b) ;
un échantillon de résonance magnétique nucléaire, NMR, (120) disposé à l'intérieur de l'espace ;
une première et une seconde bobine de radiofréquence (130a, 130b), la première bobine RF (130a) étant conçue pour introduire une impulsion RF dans l'espace obtenu dans une précession des noyaux atomiques de l'échantillon NMR (120), et la seconde bobine RF (130b) étant conçue pour mesurer la précession des noyaux atomiques de l'échantillon NRM (120), **caractérisé en ce que** la première et la seconde bobine de radiofréquence, RF, (130a, 130b) sont disposées sur des côtés différents de l'espace à un angle de 90° l'une par rapport à l'autre.

2. Boîtier physique (100) selon la revendication 1 dans lequel le premier et le second aimant permanent (110a, 110b) sont disposés à une certaine distance de sorte qu'une intensité prédéfinie du champ magnétique statique se produise à l'intérieur de l'espace , l'intensité prédéfinie correspondant à une condition de résonance magnétique nucléaire pour l'opération d'onde continue.

3. Boîtier physique (100) selon la revendication 1 ou la revendication 2 dans lequel l'espace est un cylindre ou un cuboïde, par exemple un cube.

4. Boîtier physique (100) selon la revendication 3, dans lequel le premier et le second aimant permanent (110a, 110b), et la première et la seconde bobine (130a, 130b) sont disposés de sorte que chacun d'entre eux forme une partie de différents côtés du cuboïde, ou
dans lequel le premier et le second aimant permanent (130a, 130b) sont disposés sur des côtés supérieur et inférieur respectifs du cylindre, et dans lequel la première et la seconde bobine RF (130a, 130b) sont déplacées dans le sens circonférentiel selon un angle de 90°.

5. Boîtier physique (100) selon la revendication 3 ou la revendication 4, dans lequel le premier et le second aimant permanent (110a, 110b) sont disposés sur des côtés opposés du cylindre ou du cuboïde.

6. Boîtier physique (100) selon l'une quelconque des revendications 3 à 5, dans lequel la première et la seconde bobine RF (130a, 130b) sont disposées sur des côtés adjacents du cuboïde ou sur la surface latérale du cylindre déplacé dans le sens circonférentiel du cylindre selon un angle de 90°.

7. Boîtier physique (100) selon l'une quelconque des revendications 3 à 6, dans lequel le cylindre ou le cuboïde est construit par le premier et le second aimant permanent (110a, 110b) ensemble avec la première et la seconde bobine RF (130a, 130b).

8. Boîtier physique (100) selon l'une quelconque des revendications précédentes, dans lequel les vecteurs normaux respectifs associés à la première et à la seconde bobine RF (130a, 130b) sont perpendiculaires l'un à l'autre.

9. Boîtier physique (100) ) selon la revendication 8, dans lequel les vecteurs normaux respectifs de la première et de la seconde bobine RF (13a, 130b) construisent un plan qui est perpendiculaire à un sens préféré du champ magnétique statique.

10. Boîtier physique (100) selon l'une quelconque des revendications précédentes, comprenant en outre une bobine CC (140) pour fournir un autre champ magnétique statique, la bobine CC (140) étant disposée sur la circonférence du cylindre ou du cuboïde, et la bobine CC (140) étant conçue pour régler le champ magnétique généré par le premier et le second aimant permanent (110a, 110b).

11. Boîtier physique (100) selon la revendications 10, dans lequel la bobine CC (140) est conçue pour générer l'autre champ magnétique statique dans un sens parallèle à un sens du champ magnétique statique généré par le premier et le second champ magnétique statique (110a, 110b).

12. Boîtier physique (100) selon la revendication 11, dans lequel le sens de l'autre champ magnétique statique est de préférence dans un sens perpendiculaire à un vecteur normal de la seconde bobine RF (130b).

13. Boîtier physique (100) selon l'une quelconque des revendications précédentes, comprenant en outre un château de fer (150) disposé et conçu pour entourer l'espace de sorte que les pôles contraires du premier et du second aimant permanent (110a, 110b) soient connectés l'une à l'autre.

14. Oscillateur (200) pour fournir une fréquence de sortie, l'oscillateur (200) comprenant le boîtier physique (100) selon l'une quelconque des revendications précédentes.
